# EUROPEAN PATENT APPLICATION

(11) **EP 1 132 912 A1**
(43) Date of publication of application: **12.09.2001**
(21) Application number: 01202036.8
(22) Date of filing: 13.07.1998
(51) Int. Cl.: G11B 20/10, H03M 13/00

(54) **Combined DVD/CD data processor**

(30) Priority: 30.08.1997 KR 9743697
(62) Divisional of application: 98305559.1
(71) Applicant: SAMSUNG ELECTRONICS CO. LTD., Suwon-city, Kyungki-do (KR)
(72) Inventor: Choi, Hoon-Soon, Kangdong-gu, Seoul (KR)
(74) Representative: Chugg, David John

(57) **Abstract**

A combined DVD/CD (Digital Video Disk/Compact Disk) data processor used in a DVD/CD player. The DVD/CD data processor includes a PLL (Phase Locked Loop) (52) for receiving a pulse stream input to generate a PLL clock; a frame/ID synchronization detector (54) for latching the pulse stream according to the PLL clock, to generate a symbol clock; a demodulator (56) for EFM+ demodulating the pulse stream according to the symbol clock in a DVD mode, and EFM demodulating the pulse stream according to the symbol clock in a CD mode; an ECC demodulator (62) for error-correcting input data according to a predetermined code length and error correction range, the predetermined code length and error correction range having different values in the DVD and CD modes; a memory (58) for storing the demodulated data to provide the ECC demodulator with the demodulated data stored therein; a descrambler (60) for descrambling the error corrected data stored in the memory (58), in the DVD mode; and a CD audio processor (64) for processing the error corrected data stored in the memory, in the CD mode.

## Description

The present invention relates to a DVD/CD player, and in particular, to a combined DVD/CD data processor for use in a DVD/CD player.

A DVD (Digital Video Disk) player includes optical and servo systems of which functions and structures are similar to those used in a CD (Compact Disk) player. Therefore, in order to offer convenience to the user, there have been a demand for a DVD player compatible with the CD player.

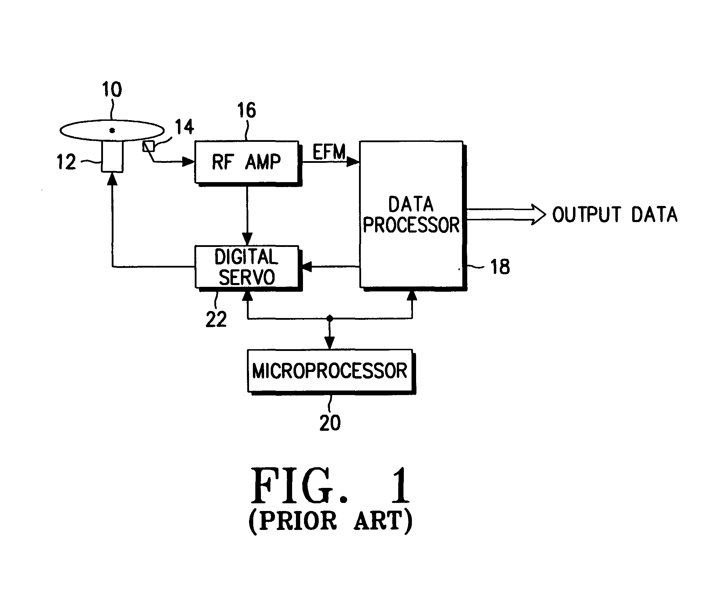

Figure 1 illustrates a schematic block diagram of a combined DVD and CD player according to the state of the art. As illustrated, a spindle motor 12 rotates a disk 10 which is a DVD or CD. An optical pickup 14 reads an RF (Radio Frequency) signal from the disk 10, and an RF amplifier 16 converts the RF signal read by the pickup 14 into a pulse stream, to generate an EFM (Eight to Fourteen Modulated) signal. A microprocessor 20 sets the DVD/CD player to a DVD mode or a CD mode, according to lead-in information received from the RF amplifier 16. A data processor 18 processes the EFM signal according to the set operation mode.

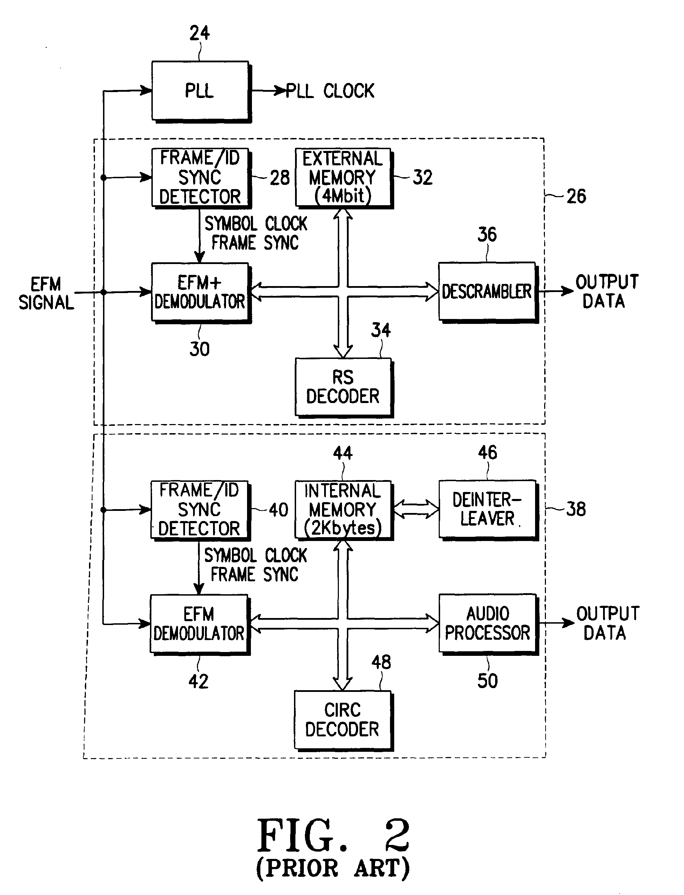

Figure 2 illustrates the data processor 18 according to the prior art. In operation, the EFM signal is applied in common to a phase locked loop (hereinafter, referred to as PLL)24, a DVD data processor 26, and a CD data processor 38. The PLL 24 generates a PLL clock in synchronism with the EFM signal. The PLL clock is used for reproducing data recorded on the disk 10.

If the microprocessor 20 sets the DVD/CD player to the DVD or CD mode according to the lead-in information, one of the DVD data processor 26 and the CD data processor 38 is selectively driven.

The DVD data processor 26 includes a frame/ID (Identification) synchronization detector 28, an EFM+ (Eight to Fourteen Modulation Plus) demodulator 30, an RS (Reed-Solomon) decoder 34, an external memory 32, and a descrambler 36. The frame/ID synchronization detector 28 detects a synchronization pattern from the EFM signal to generate a symbol clock to the EFM+ demodulator 30. The EFM+ demodulator 30 EFM+ demodulates the EFM signal according to the symbol clock, and stores the demodulated data into the external memory 32. If the demodulated data stored in the external memory 32 becomes as large as a ECC (Error Checking and Correction) block size, the RS decoder 34 reads the demodulated data with the ECC block size and RS-decodes it to correct errors of the data. The error corrected data is stored back into the external memory 32. The descrambler 36 reads the error corrected data stored in the external memory 32 to descramble the read data and provide it to an external ATAPI (AT Attachment Packet Interface). Here, in case the DVD/CD player is set to the DVD mode, the descrambled data is applied to an AV (AudioVisual) decoder.

The CD data processor 38 includes a frame/ID synchronization detector 40, an EFM demodulator 42, an internal memory 44, a deinterleaver 46, a CIRC (Cross Interleave Reed Solomon Code) decoder 48, and an audio processor 50. The frame/ID synchronization detector 40 detects the synchronization pattern from the EFM signal to generate a symbol clock to the EFM demodulator 42. The EFM demodulator 42 EMF-demodulates the EFM signal according to the symbol clock. The demodulated data is deinterleaved by the deinterleaver 46 and stored into the internal memory 44. If the demodulated data stored in the internal memory 44 becomes a predetermined size, the CIRC decoder 48 reads the demodulated data from the internal memory 44 and CIRC-decodes it to correct errors of the data. The audio processor 50 processes the error corrected data.

As described above, the conventional DVD/CD player includes the DVD data processor 26 and the CD data processor 38 separately, and drives one of them according to the set operation mode, which results in an increase of the complexity of the device as well as the manufacturing cost.

It is therefore an aim of preferred embodiments of the present invention to provide a combined DVD and CD data processor for use in a DVD/CD player.

According to an aspect of the invention, there is provided a combined DVD/CD data processor used in a DVD/CD player. The DVD/CD data processor includes a PLL for receiving a pulse stream input to generate a PLL clock; a frame/ID synchronization detector for latching the pulse stream according to the PLL clock, to generate a symbol clock; a demodulator for EFM+ demodulating the pulse stream according to the symbol clock in a DVD mode, and EFM demodulating the pulse stream according to the symbol clock in a CD mode; an ECC demodulator for error-correcting input data according to a predetermined code length and error correction range, the predetermined code length and error correction range having different values in the DVD and CD modes; a memory for storing the demodulated data to provide the ECC demodulator with the demodulated data stored therein; a descrambler for descrambling the error corrected data stored in the memory, in the DVD mode; and a CD audio processor for processing the error corrected data stored in the memory, in the CD mode.

According to another aspect of the invention there is provided a combined DVD (Digital Video Disk)/CD (Compact disk) data processor, comprising: a PLL (Phase Locked Loop) for receiving a pulse stream input to generate a PLL clock; a frame/ID (identification) synchronization detector for latching the pulse stream according to said PLL clock, to generate a symbol clock; a demodulator for EFM+ demodulating said pulse stream according to said symbol clock in a DVD mode, and EFM demodulating said pulse stream according to said symbol clock in a CD mode; an ECC (error checking and correction) demodulator for error-correcting input data according to a predetermined code length and error correction range, said predetermined code length and error correction range having different values in said DVD and CD modes; a memory for storing the demodulated data both in the DVD mode and in the CD mode to provide said ECC demodulator with the demodulated data stored therein and storing error-corrected output data from the ECC; a descrambler for descrambling said error corrected data stored in said memory, in said DVD mode; and a CD audio processor for processing said error corrected data stored in said memory, in said CD mode.

Preferably, said predetermined code word and correction range in said DVD mode are PI(182,172), PO (208, 192), wherein said predetermined code word and correction range in said CD mode are C1(32,28), C2(28,24).

Preferably, said ECC demodulator comprises: a syndrome generator for receiving said demodulated data from said memory to generate a syndrome polynomial according to said code length and correction range of PI(182,172), PO(208,192) in said DVD mode, and of C1(32,28), C2(28,24) in said CD mode; an erasure constant generator for receiving an erasure flag to generate an erasure constant; a modified syndrome calculator for receiving said syndrome polynomial and said erasure constant to calculate a modified syndrome and generate a Forney syndrome polynomial and an erasure polynomial; a modified Euclidean algorithm for processing said Forney syndrome polynomial and said erasure polynomial based on a modified Euclidean algorithm, to generate an errata locator polynomial and an errata evaluator polynomial; and a Chien search and error correction circuit for correcting errors of the input data according to said errata locator polynomial and said errata evaluator polynomial.

Preferably, said memory is an external memory.

In another aspect, there is provided data processor apparatus for common use in a DVD (Digital Video Disk) and a CD (Compact Disk) apparatus using mode setting information provided according to whether a disk is a DVD or a CD, comprising: a PLL for generating a clock from a pulse stream read from a disk and a demodulator for performing demodulation according to the mode setting information; a memory unit for storing data demodulated by the demodulator in a corresponding format of EFM + for DVD and EFM for CD according to the mode setting information; and an ECC decoder for reading and correcting the data stored in the memory unit according to the mode setting information which is stored in a mode setting unit.

The apparatus may further comprise a CD audio processor and descrambler for audio converting and data converting the error corrected data according to the mode setting information.

Preferably, the ECC decoder is an error corrector for error correcting the data stored in the memory unit according to the mode setting information using a preset error correcting method.

Preferably, the error correcting method of the error corrector depends on a code length and a correcting range set according to the mode setting information.

According to another aspect, there is provided a data processor apparatus for sharing a memory according to mode setting information which depends on whether a type of information disk is DVD or CD, the apparatus comprising: a demodulator for performing demodulation in an EFM+ format for DVD or an EFM format for CD according to mode setting information; a memory unit for storing data processed by the demodulator in either the EFM+ or EFM format according to the mode setting information; and ECC decoder for reading and correcting the data stored in the memory unit.

There is preferably provided a PLL for generating a clock from a pulse stream read from the disk.

The data processor apparatus further comprise CD audio processor and descrambler for audio converting and data converting the error corrected data according to the mode setting information.

Preferably, the ECC decoder is an error corrector for error correcting the data stored in the memory unit according to the mode setting information using a preset error correcting method.

The error correcting method of the error corrector may depend on a code length and a correcting range according to the mode setting information.

According to a further aspect, there is provided a CD/DVD player, comprising: a micro processor for providing a DVD/CD data processor with mode setting information through a signal read from the disk and outputting mode setting information according to the disk type; a demodulator for performing demodulation in an EFM+ format for DVD or an EFM format for CD according to mode setting information; a memory unit for storing data processed by the demodulator in either the EFM+ or EFM format according to the mode setting information; and an ECC decoder for reading and correcting the data stored in the memory unit.

For a better understanding of the invention, and to show how embodiments of the same may be carried into effect, reference will now be made, by way of example, to the accompanying diagrammatic drawings, in which:
Figure 1 is a schematic block diagram of a general DVD/CD player;
Figure 2 is a detailed block diagram of a data processor of Figure 1 according to the prior art;
Figure 3 is a detailed block diagram of a data processor according to a preferred embodiment of the present invention;
Figures 4 and 5 are diagrams illustrating memory maps of an external memory of the Figure 3 embodiment; and
Figure 6 is a detailed block diagram of an ECC decoder of Figure 3 according to a preferred embodiment.

A preferred embodiment of the present invention will be described in detail, and it should be noted that like reference numerals denote the same components, and a detailed description of known function and structure of the present invention will be avoided if it is deemed to obscure the subject matter of the present invention.

A combined DVD/CD data processor according to the present invention is applicable to the DVD/CD player shown in Figure 1, and the microprocessor 20 provides the DVD/CD data processor with mode setting information for setting the DVD or CD mode.

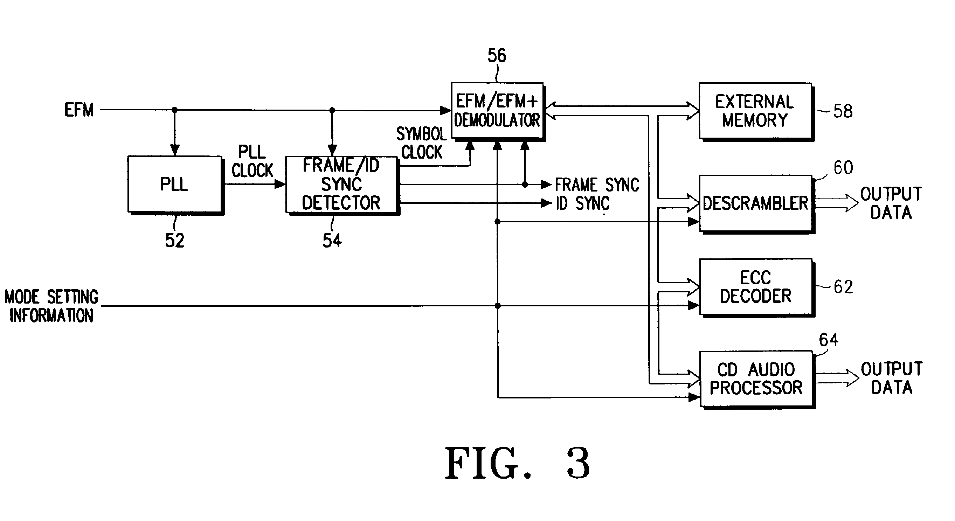

Referring to Figure 3, the DVD/CD data processor includes a PLL 52, a frame/ID synchronization detector 54, an EFM/EFM+ demodulator 56, an external memory 58 consisting of a DRAM (dynamic random access memory), a descrambler 60, an ECC decoder 62, and a CD audio processor 64.

The PLL 52 receives the EFM signal from the RF amplifier 16 to generate a PLL clock for restoring data, in synchronism with the received EFM signal. The frame/ID synchronization detector 54 latches the EFM signal according to the PLL clock, and detects frame synchronization and ID synchronization signals to generate a symbol clock. The EFM/EFM+ demodulator 56 selectively performs EFM or EFM+ demodulation according to the mode setting information generated from the microprocessor 20. That is, if the mode setting information indicates the DVD mode, the EFM/EFM+ demodulator 56 EFM+ demodulates the EFM signal according to the symbol clock. On the contrary, if the mode setting information indicates the CD mode, the EFM/EFM+ demodulator 56 EFM demodulates the EFM signal according to the symbol clock. Such demodulated data is stored into the external memory 58.

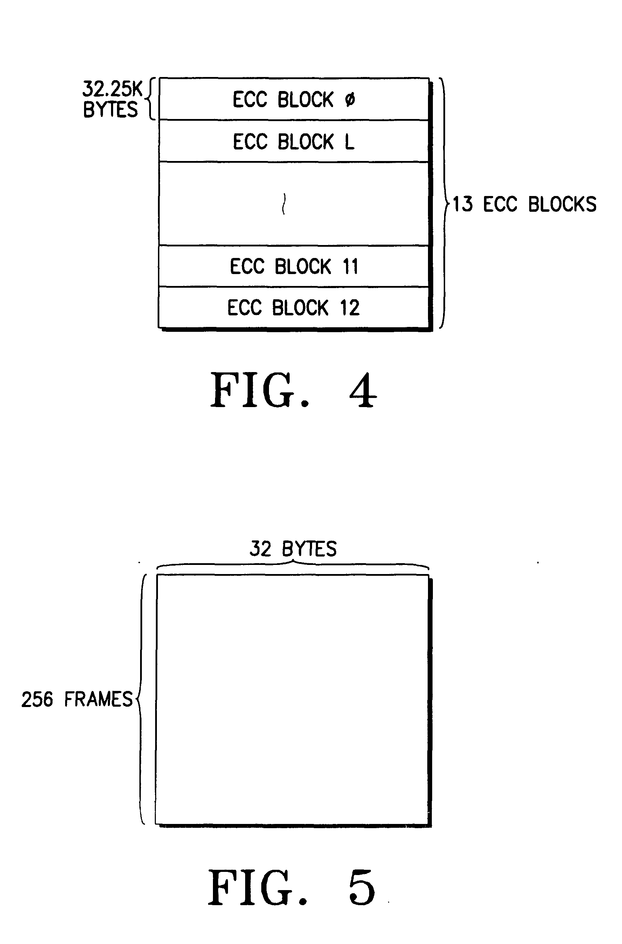

The external memory 58 has a memory map as shown in FIGs. 4 and 5. In the DVD mode, the external memory 58 has 13 ECC blocks each having 32.25-Kbytes to store 13 ECC blocks, as shown in Figure 4. The external memory 58 is such configured in order to provide a VBR (Variable Bit Rate) control margin for interfacing VBR coded AV data with the AV decoder. In the CD mode, a specified part, i.e., 32bytes x 256 frames, of the external memory 58 is used, as shown in Figure 5.

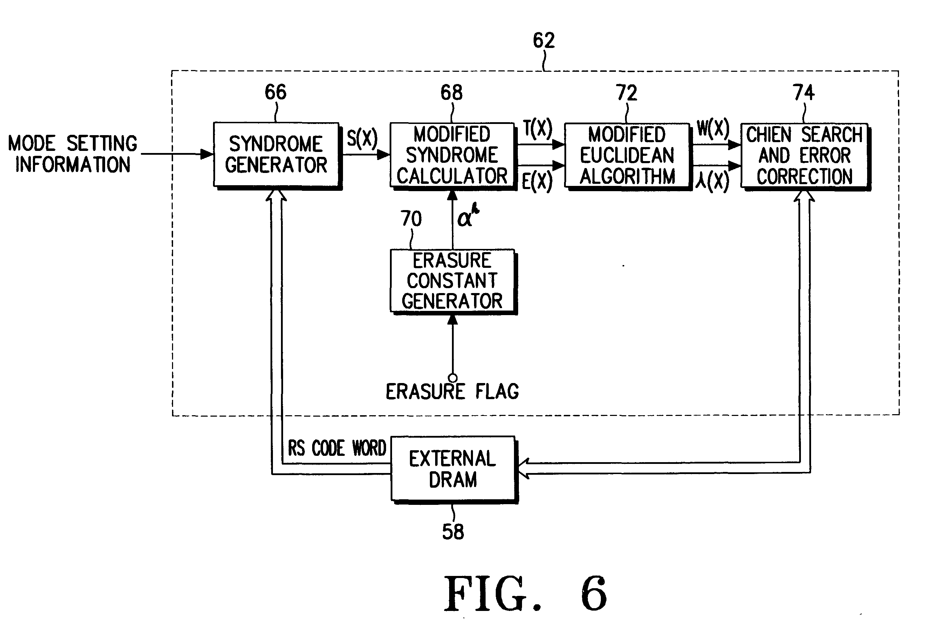

Referring back to Figure 3, the ECC decoder 62 reads and corrects the data stored in the external memory 58 according to the mode setting information. The ECC decoder 62 has a construction as shown in Figure 6.

Referring to Figure 6, the ECC decoder 62 includes a syndrome generator 66, a modified syndrome calculator 68, an erasure constant generator 70, a modified Euclidean algorithm 72, a Chien search and error correction circuit 74.

In the DVD mode, the syndrome generator 66 sets a code length and a correction range to PI(182,172), PO(208,192) and thereafter, receives data from the external memory 58 to generate a syndrome polynomial S(X). In the CD mode, the syndrome generator 66 sets the code length and correction range to C1(32,28), C2(28,24) and thereafter, receives the data from the external memory 58 to generate the syndrome polynomial S(X). The generated syndrome polynomial S(X) is applied to the modified syndrome calculator 68. The erasure constant generator 70 is provided with an erasure flag to generate an erasure constant a^{k} to the modified syndrome calculator 68. The modified syndrome calculator 68 receives the syndrome polynomial S(X) and the erasure constant a^{k} to calculate a Forney syndrome polynomial T (X) and an erasure locator polynomial E(X). The calculated Forney syndrome polynomial T(X) and erasure locator polynomial E(X) are applied to the modified Euclidean algorithm 72. The modified Euclidean algorithm 72 processes the Forney syndrome polynomial T(X) and the erasure locator polynomial E(X) based on the modified Euclidean algorithm, to generate an errata locator polynomial W(X) and an errata evaluator polynomial Ë(X). The Chien search and error correction circuit 74 receives the errata locator polynomial W(X) and an errata evaluator polynomial Ë(X) to correct errors of the corresponding data and store the error corrected data back into the external memory 58.

Since the primitive polynomials for error-correcting the DVD data and the CD data are the same to each other, it is possible to correct the DVD and CD data by controlling only the data received from the syndrome generator 66, with use of the single ECC decoder 62. The primitive polynomial P(X) is represented by:${\text{P(X) = x}}^{\text{8}} {\text{+ x}}^{\text{4}} {\text{+ x}}^{\text{3}} {\text{+ x}}^{\text{2}} \text{+ 1}$

That is, the primitive polynomials for correcting the DVD and CD data are the same to equation (1), and merely, the code lengths and correction ranges of the DVD and CD data to be error-corrected are different from each other. Therefore, by simply controlling the code length and the correction range of the input data according to the set mode, it is possible to correct errors of the DVD and CD data with use of the single ECC decoder 62.

Referring again to Figure 3, in case the DVD/CD player is set to the DVD mode, the descrambler 60 is enabled to descramble the error corrected data stored in the external memory 58 and provide the descrambled output data to the ATAPI (not shown) or the AV decoder (not shown).

In case the DVD/CD player is set to the CD mode, the CD audio processor 64 is enabled to process the error corrected data stored in the external memory 58.

As can be appreciated from the foregoing, the DVD/CD data processor includes a single ECC decoder for correcting both the DVD and CD data, and a single external memory. Therefore, the DVD/CD data processor is simple in structure, thereby resulting in a decrease of the manufacturing cost.

While the invention has been shown and described with reference to certain preferred embodiments thereof, it will be understood by those skilled in the art that various changes in form and details may be made therein without departing from the scope of the invention as defined by the appended claims.

The reader's attention is directed to all papers and documents which are filed concurrently with or previous to this specification in connection with this application and which are open to public inspection with this specification, and the contents of all such papers and documents are incorporated herein by reference.

All of the features disclosed in this specification (including any accompanying claims, abstract and drawings), and/or all of the steps of any method or process so disclosed, may be combined in any combination, except combinations where at least some of such features and/or steps are mutually exclusive.

Each feature disclosed in this specification (including any accompanying claims, abstract and drawings), may be replaced by alternative features serving the same, equivalent or similar purpose, unless expressly stated otherwise. Thus, unless expressly stated otherwise, each feature disclosed is one example only of a generic series of equivalent or similar features.

The invention is not restricted to the details of the foregoing embodiment(s). The invention extends to any novel one, or any novel combination, of the features disclosed in this specification (including any accompanying claims, abstract and drawings), or to any novel one, or any novel combination, of the steps of any method or process so disclosed.

## Claims

1. A data processor apparatus for common use in a DVD (Digital Video Disk) and a CD (Compact Disk) apparatus using mode setting information provided according to whether a disk is a DVD or a CD, comprising:
a PLL for generating a clock from a pulse stream read from a disk and a demodulator for performing demodulation according to the mode setting information;
a memory unit for storing data demodulated by the demodulator in a corresponding format of EFM + for DVD and EFM for CD according to the mode setting information; and
an ECC decoder for reading and correcting the data stored in the memory unit according to the mode setting information which is stored in a mode setting unit.

2. The data processor apparatus as claimed in claim 1, further comprising a CD audio processor and descrambler for audio converting and data converting the error corrected data according to the mode setting information.

3. The data processor apparatus as claimed in claim 1, wherein the ECC decoder is an error corrector for error correcting the data stored in the memory unit according to the mode setting information using a preset error correcting method.

4. The data processor apparatus as claimed in claim 3, wherein the error correcting method of the error corrector depends on a code length and a correcting range set according to the mode setting information.

5. A data processor apparatus for sharing a memory according to mode setting information which depends on whether a type of information disk is DVD or CD, the apparatus comprising:
a demodulator for performing demodulation in an EFM+ format for DVD or an EFM format for CD according to mode setting information;
a memory unit for storing data processed by the demodulator in either the EFM+ or EFM format according to the mode setting information; and
ECC decoder for reading and correcting the data stored in the memory unit.

6. The data processor apparatus as claimed in claim 5, wherein there is provided a PLL for generating a clock from a pulse stream read from the disk.

7. The data processor apparatus as claimed in claim 5, further comprising a CD audio processor and descrambler for audio converting and data converting the error corrected data according to the mode setting information.

8. The data processor apparatus as claimed in claim 5, wherein the ECC decoder is an error corrector for error correcting the data stored in the memory unit according to the mode setting information using a preset error correcting method.

9. The data processor apparatus as claimed in claim 8, wherein the error correcting method of the error corrector depends on a code length and a correcting range according to the mode setting information.

10. A CD/DVD player , comprising:
a micro processor for providing a DVD/CD data processor with mode setting information through a signal read from the disk and outputting mode setting information according to the disk type;
a demodulator for performing demodulation in an EFM+ format for DVD or an EFM format for CD according to mode setting information;
a memory unit for storing data processed by the demodulator in either the EFM+ or EFM format according to the mode setting information; and
an ECC decoder for reading and correcting the data stored in the memory unit.
